# EUROPEAN PATENT APPLICATION

(11) **EP 1 780 801 A1**
(43) Date of publication of application: **02.05.2007**
(21) Application number: 05752958.8
(22) Date of filing: 24.06.2005
(51) Int. Cl.: H01L 31/042

(54) **SOLAR CELL PANEL**

(30) Priority: 07.07.2004 JP 2004201019
(71) Applicant: TOHOKU UNIVERSITY, Sendai, Miyagi 980-8577 (JP)
(72) Inventor: OHMI, Tadahiro, Sendai-shi, Miyagi 9800813 (JP); MORIMOTO, Akihiro, Sendai-shi, Miyagi 9893128 (JP); TAKEHISA, Kiwamu, Aoba-ku, Sendai-shi, Miyagi 9800866 (JP)
(74) Representative: Glawe, Delfs, Moll
(86) International application number: PCT/JP2005/011587
(87) International publication number: WO 2006/006372

(57) **Abstract**

Generally, solar cell panels are black, being inferior in design. An object of the invention is to provide a transparent plate which develops color without lowering power generation efficiency; and a solar cell panel which uses such transparent plate. A solar cell panel according to the invention has a construction such that the solar cell is covered by a transparent plate which is **characterized by** absorbing infrared light and emitting visible light. Since the transparent plate develops color by using infrared light which does not contribute to power generation, there is obtained a solar cell panel which is superior in the viewpoint of decoration without lowering the power generation efficiency of solar cells.

## Description

### Technical Field

This invention relates to a structure of a solar cell panel and a transparent plate for use in the solar cell panel.

### Background Art

Generally, solar cell panels made of amorphous silicon or single-crystal silicon efficiently absorb the sunlight and, therefore, power generation efficiency (i.e. the ratio of the electric power generated by a solar cell relative to all the power radiated by the sunlight) often exceeds 20%. However, the solar cell panels made of amorphous silicon or single-crystal silicon are normally black on the whole and are thus limited in design. Therefore, when they are arranged on the roofs of general houses being conspicuous places, and so on, there are instances where views are marred in appearance. As a result, there is a cause for delaying the spread of solar cell panels.

On the other hand, there have conventionally been proposed various attempts to color solar cell panels. For example, Japanese Unexamined Patent Application Publication (JP-A) No. S60-148174 (hereinafter referred to as Patent Document 1) discloses a solar cell provided with a selective reflection layer for selectively reflecting part of the visible light spectrum. When the selective reflection film for reflecting part of the visible spectrum of the sunlight is coated as in Patent Document 1, an observer can see the color of the spectrum of reflected visible light. Consequently, the colored solar cell can be obtained.

Further, Japanese Examined Utility Model Publication (JP-Y) No. H7-29646 (hereinafter referred to as Patent Document 2) discloses a solar cell provided with a wavelength selective scattering layer for scattering, in all directions, particular-wavelength light in the visible spectrum including light in a wavelength range that contributes to power generation of the solar cell, thereby causing part of the scattered light to reach an observer, while adapted to transmit light other than the particular-wavelength light.

Patent Document 1: Japanese Unexamined Patent Application Publication (JP-A) No. S60-148174
Patent Document 2: Japanese Examined Utility Model Publication (JP-Y) No. H7-29646

### Disclosure of the Invention

### Problem to be Solved by the Invention

When the selective reflection layer or the wavelength selective scattering layer is provided for reflecting or scattering part of the visible light spectrum as described in Patent Document 1 or 2, the part of the visible light spectrum is not used for power generation of the solar cell. Therefore, it has been a problem that the power generation efficiency is theoretically lowered according to the technique disclosed in Patent Document 1 or 2.

It is an object of this invention to provide a solar cell panel adapted to develop color without theoretically lowering the power generation efficiency.

It is another object of this invention to provide a visible-light transparent plate that does not lower the power generation efficiency of a solar cell.

### Means for Solving the Problem

A solar cell panel according to this invention comprises a transparent plate for absorbing infrared light and emitting visible light and a solar cell covered with said transparent plate.

In this invention, for the transparent plate for absorbing the infrared light and emitting the visible light, use is made of a material containing two or more kinds of lanthanoid series atoms (or ions thereof), particularly a glass. Of at least the two kinds of atoms, an atom that efficiently absorbs the infrared light can be selected as one atom and an atom that produces the visible light can be selected as the other atom. Since the lanthanoid series atoms doped into the foregoing material behave as ions upon performing color developing operation, the material can also be a material containing these ions.

Further, according to this invention, as a transparent plate for use in a solar cell panel, there is obtained a transparent plate for a solar cell, which has a property of absorbing infrared light and emitting visible light.

### Effect of the Invention

According to this invention, since the color is developed based on the solar energy of the infrared components that do not contribute to the power generating operation of the solar cell, the power generation efficiency of the solar cell is not lowered.

Further, according to this invention, since various light-emitting panels can be realized, there is obtained an effect also excellent in terms of decoration as compared with the conventional black panels.

### Brief Description of the Drawings

[Fig. 1] (a) and (b) are explanatory diagrams showing an outline and an operation principle of a solar cell panel according to a first example of this invention, respectively.
[Fig. 2] (a) and (b) are explanatory diagrams showing an outline and an operation principle of a solar cell panel according to a second example of this invention, respectively.
[Fig. 3] A graph showing the sunlight spectrum.
[Fig. 4] A graph showing the sensitivity characteristics of a silicon solar cell.
[Fig. 5] A graph showing the absorption characteristics of the silicon solar cell.

### Description of Symbols

- 10, 20: solar cell panel
- 11, 21: transparent plate
- 12, 22: solar cell
- L1: sunlight
- L2: visible light

### Best Mode for Carrying Out the Invention

Hereinbelow, an embodiment of this invention will be described with reference to the drawings.

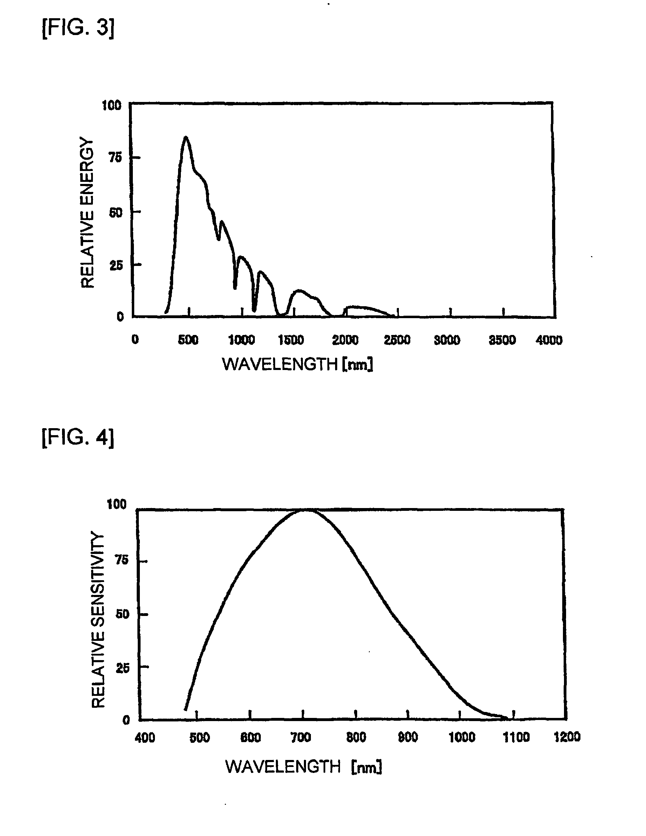

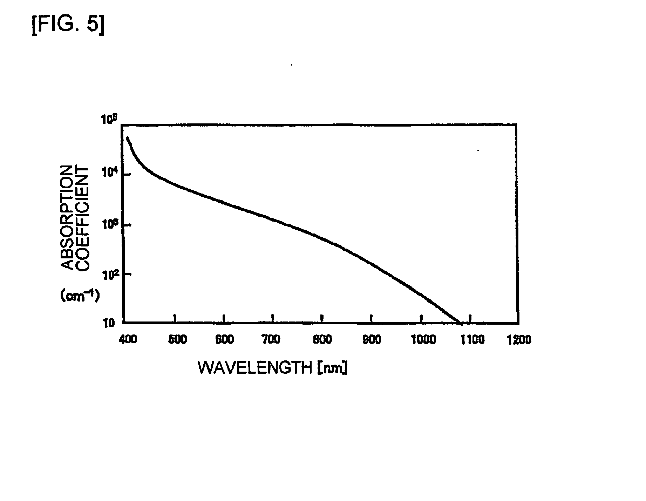

A solar cell panel made of amorphous silicon or single-crystal silicon absorbs the sunlight and generates the power based on the energy radiated by the sunlight. The sunlight spectrum shown in Fig. 3 includes a wide range from a visible region to an infrared region longer than 1000nm. However, as seen from the sensitivity characteristics of a general silicon solar cell shown in Fig. 4 and the absorption spectrum of the silicon solar cell shown in Fig. 5, it is understood that the infrared light of 1000nm or more is hardly used for solar cell power generation.

This invention is configured such that a solar cell is covered with a transparent plate made of a material for converting , into visible light, the energy of the infrared light of 1000nm or more that is hardly used for the solar cell power generation. Thus, it is provided a solar cell panel and the solar cell panel transparent plate for developing color without lowering the power generation efficiency of the solar cell at all.

For the transparent plate that absorbs the infrared light and emits the visible light, use is particularly made of a material containing two or more kinds of lanthanoid series atoms (or ions thereof), particularly a glass. Specifically, of at least the two kinds of atoms, an atom that efficiently absorbs the infrared light can be selected as one atom and an atom that produces the visible light can be selected as the other atom. Since the lanthanoid series atoms doped into the foregoing material behave as ions upon performing color developing operation, the material can also be expressed as a material containing these ions.

According to the embodiment of this invention, since the color is developed based on the solar energy of the infrared components that do not contribute to the power generating operation of the solar cell, the power generation efficiency of the solar cell is not lowered. Further, according to this invention, since various light-emitting panels can be realized, there is obtained an effect also excellent in terms of decoration as compared with the conventional black panels.

Hereinbelow, examples of this invention will be described in detail with reference to the drawings.

### Example 1

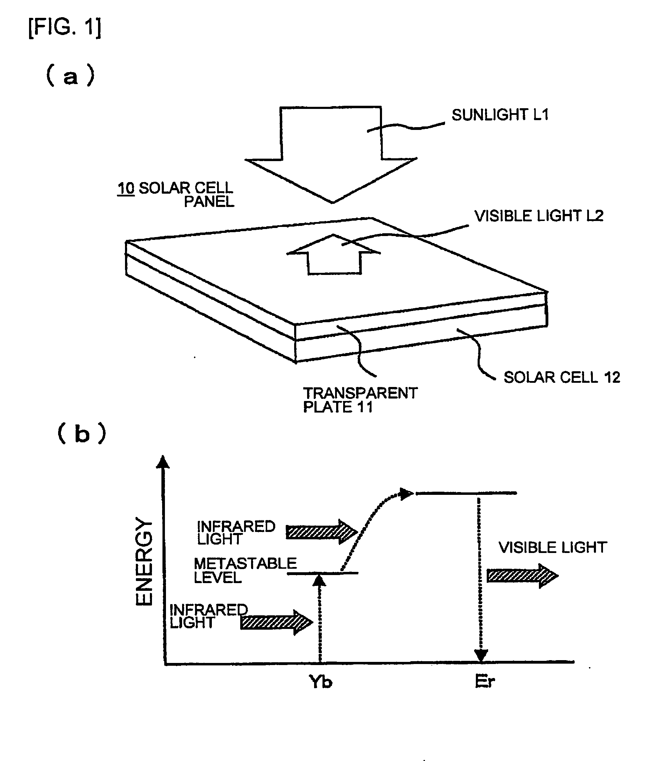

The first example of this invention will be described using Fig. 1, (a) and (b). Fig. 1, (a) and (b) are explanatory diagrams showing an outline of a solar cell panel 10 being the first example of this invention and an operation principle thereof. The shown solar cell panel 10 comprises a solar cell 12 using amorphous silicon and a transparent plate 11 having a thickness of about 5mm and bonded to the solar cell 12. The transparent plate 11 is made of Pyrex (registered trademark) glass in which ytterbium (Yb) and erbium (Er) are doped as two kinds of lanthanoid series atoms (also including ionized atoms).

Ytterbium (Yb) has the property of absorbing photons of infrared light having a wavelength near 1000nm and, when sunlight L1 is irradiated, it is excited to a metastable state by infrared components included therein. Since this level is relatively long, Ytterbium (Yb) can further absorb photons of the infrared light and thus further excited to a higher level corresponding to an energy level of visible light until deactivated to a ground level. There, the energy can be transferred to erbium (Er) having many energy levels in the visible region, so that the erbium (Er) emits visible light L2. Since the generated visible light L2 is emitted in all directions, the transparent plate is observed to be colored by the visible light diverging to the opposite side with respect to the solar cell 12. The visible light proceeding to the solar cell 12 side is used for power generation of the solar cell.

In this example, use is made, as the transparent plate, of the Pyrex (registered trademark) glass doped with the two kinds, i.e. ytterbium (Yb) and erbium (Er). The energy of the infrared light is absorbed by the ytterbium (Yb) and, further, the erbium (Er) transferred with the energy emits the visible light. Since the color is developed based on the solar energy of the infrared components that do not contribute to the power generating of the solar cell, there is obtained the solar cell panel that does not reduce the power generation efficiency of the solar cell and is excellent also in terms of decoration.

### Example 2

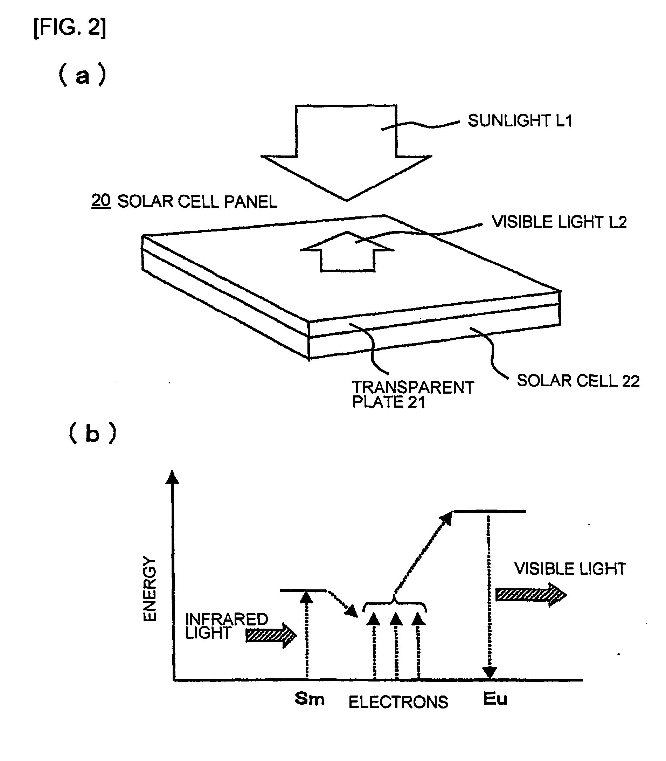

A solar cell panel according to the second example of this invention will be described using Fig. 2, (a) and (b). Fig. 2, (a) is a perspective view showing an outline of a solar cell panel 20 and Fig. 2, (b) is a diagram for explaining an operation principle thereof. The shown solar cell panel 20 comprises a solar cell 22 using single-crystal silicon and a transparent plate 21 bonded to the solar cell 22. The shown transparent plate 21 is made of soda glass in which samarium (Sm) and europium (Eu) are doped as two kinds of lanthanoid series atoms.

Herein, the principle of the solar cell panel according to this example will be explained. When sunlight L1 is applied to the transparent plate 21, electrons having energy are produced by samarium (Sm) absorbing infrared light included in the sunlight L1, so that visible light L2 is generated upon recombination of europium (Eu) with the electrons. In this manner, the solar - cell panel 20 is observed to be colored. In this case, cerium (Ce) may be used instead of europium (Eu) in this example.

In this example, use is made, as the transparent plate, of the soda glass doped with the two kinds of lanthanoid series atoms. Since the transparent plate is colored based on the solar energy of the infrared components that do not contribute to the operation of the solar cell, there is obtained the solar cell panel that does not reduce the power generation efficiency of the solar cell and is excellent also in terms of decoration.

Either of the transparent plates based on the principles of the examples 1 and 2 may be used as a transparent plate suitable for a solar cell panel of this invention. Since coloring differs depending on the kind of atom added to a transparent plate, it is possible to provide a solar cell panel adapted to develop various colors.

In the foregoing examples, the description has been given only of the case where the glass is used as the transparent plate. However, a transparent plate according to this invention is not limited to a glass and, for example, may be made of transparent plastic.

### Industrial Applicability

A solar cell panel according to this invention does not mar aesthetic appearance even if it is attached to a vertical wall that is more conspicuous than a roof of a general house and, hence, it is particularly suitable for a wall of a multistory building. Further, in the case of a body of an automobile or a train, or the like, the aesthetic appearance is not marred by attaching a transparent plate adapted to develop the same color as the original coating color.

Further, since it is possible to realize a solar cell panel capable of various light emissions by selecting a proper combination of elements that generate visible lights, it can not only be used as a photoelectric conversion element, i.e. a solar cell, but also be positively used for a building or the like as an outer wall material having a decorative function.

As described above, since much demand can be expected for this invention, the energy saving effect over the whole country increases significantly.

## Claims

1. A solar cell panel, comprising a transparent plate for absorbing infrared light and emitting visible light, and a solar cell covered with said transparent plate.

2. A solar cell panel according to claim 1, wherein said transparent plate contains two or more kinds of lanthanoid series atoms or ions.

3. A solar cell panel according to claim 2, wherein the two kinds of said lanthanoid series atoms or ions are samarium (Sm) and europium (Eu) or ions of samarium (Sm) and europium (Eu).

4. A solar cell panel according to claim 2, wherein the two kinds of said lanthanoid series atoms or ions are samarium (Sm) and cerium (Ce) or ions of samarium (Sm) and cerium (Ce).

5. A solar cell panel according to claim 2, wherein the two kinds of said lanthanoid series atoms or ions are ytterbium (Yb) and erbium (Er) or ions of ytterbium (Yb) and erbium (Er).

6. A transparent plate for a solar cell, wherein the transparent plate has a property of absorbing infrared light and emitting visible light.

7. A transparent plate for a solar cell according to claim 6, wherein the transparent plate contains at least two kinds of lanthanoid series atoms or ions.

8. A transparent plate for a solar cell according to claim 7, wherein the transparent plate is made of a glass plate including Pyrex (registered trademark) glass or soda-lime glass.

9. A transparent plate for a solar cell according to claim 7, wherein said lanthanoid series atoms or ions are selected from the group consisting of Sm, Eu, Ce, Yb, and Er.

10. A transparent plate for a solar cell according to claim 8, wherein said lanthanoid series atoms or ions are selected from the group consisting of Sm, Eu, Ce, Yb, and Er.

11. A transparent plate for a solar cell according to any of claims 6 to 10, wherein the transparent plate is used so as to be attached to a surface of a solar cell.
